# EUROPEAN PATENT APPLICATION

(11) **EP 2 937 910 A1**
(43) Date of publication of application: **28.10.2015**
(21) Application number: 13864974.4
(22) Date of filing: 16.12.2013
(51) Int. Cl.: H01L 31/0687, H01L 31/0224

(54) **SOLAR CELL AND METHOD FOR PRODUCING SAME**

(30) Priority: 18.12.2012 JP 2012275839
(71) Applicant: PVG Solutions Inc., Kohoku-ku Yokohama-shi Kanagawa 222-0033 (JP)
(72) Inventor: GODA, Shinji, Yokohama-shi Kanagawa 222-0033 (JP); KANO, Yasuyuki, Yokohama-shi Kanagawa 222-0033 (JP); OKU, Ryosuke, Yokohama-shi Kanagawa 222-0033 (JP); KATO, Futoshi, Yokohama-shi Kanagawa 222-0033 (JP); OGINO, Takayuki, Yokohama-shi Kanagawa 222-0033 (JP); ISHIKAWA, Naoki, Yokohama-shi Kanagawa 222-0033 (JP)
(74) Representative: Samson & Partner Patentanwälte mbB
(86) International application number: PCT/JP2013/083587
(87) International publication number: WO 2014/098016

(57) **Abstract**

[Problem] To provide a solar battery cell such that higher conversion efficiency than ever before is achieved and conversion efficiency of its front surface and conversion efficiency of its rear surface become almost equivalent in a double-sided light-receiving type solar battery cell.

[Solution] There is provided a solar battery cell including: an n-type silicon substrate having a thickness of not less than 100 µm nor more than 250 µm; a p-type diffusion layer formed on a first light-receiving surface being a front surface of the silicon substrate; an n-type diffusion layer formed on a second light-receiving surface being a rear surface of the silicon substrate; an anti-reflection film formed on the p-type diffusion layer and the n-type diffusion layer; a plurality of grid electrodes and a plurality of busbar electrodes that are formed on part of the p-type diffusion layer; and a plurality of grid electrodes and a plurality of busbar electrodes that are formed on part of the n-type diffusion layer.

## Description

### [Technical Field]

The present invention relates to a solar battery cell and a method of manufacturing the same.

This application is based upon and claims the benefit of priority of the prior Japanese Patent Application No. 2012-275839, filed on December 18, 2012, the entire contents of which are incorporated herein by reference.

### [Background Art]

Solar battery cells (hereinafter, also simply referred to as cells) are semiconductor elements converting incident light energy to electric power and include a p-n junction type, a pin type, a Schottky type, and so on, among which the p-n junction type is especially in wide use. Further, if solar batteries are classified based on a substrate material, they are roughly classified into three kinds, that is, a silicon crystal-based solar battery, an amorphous silicon-based solar battery, and a compound semiconductor-based solar battery. The silicon crystal-based solar battery is further classified into a single crystal solar battery and a polycrystalline solar battery. Since a silicon crystal substrate for solar batteries can be relatively easily manufactured, the silicon crystal-based solar battery is most widely used.

A demand for solar batteries has recently been increased as a clean energy source, and accordingly, a demand for solar battery cells has also been increased. Further, in view of energy efficiency, it is desired that solar battery cells have as high conversion efficiency from light energy to electric power (hereinafter, also simply referred to as conversion efficiency) as possible.

As a technique of increasing conversion efficiency of a solar battery cell, for example, Patent Document 1 discloses a solar battery element (solar battery cell) having a constitution in which the number of busbar electrodes is increased and the length of finger electrodes is shortened, and a solar battery module using the same. The solar battery module described in Patent Document 1 has a constitution in which three front-surface busbar electrodes and a plurality of finger electrodes are provided on a front surface (light-receiving surface) of a semiconductor substrate and three rear-surface busbar electrodes are provided on a rear surface (not-light-receiving surface) of the semiconductor substrate.

### [Prior Art Document]

### [Patent Document]

Patent Document 1: Japanese Patent No. 4953562

### [Disclosure of the Invention]

### [Problems to Be Solved by the Invention]

As described above, single-sided light-receiving type cells are used for the above-described solar battery module described in Patent Document 1, and the upper limit value of conversion efficiency of the above cells is about greater than 17%. However, in recent years, higher efficiency of a solar battery cell is required and there is such a circumstance that the invention described in Patent Document 1 is not enough to obtain sufficient conversion efficiency.

Further, in order to achieve higher efficiency of a solar battery cell, a double-sided light-receiving type solar battery cell is also developed recently, but there is such a circumstance that the development of a technique of making both conversion efficiency of a front surface and conversion efficiency of a rear surface sufficient and making the conversion efficiency of the front surface and the conversion efficiency of the rear surface become almost equivalent does not advance yet.

In consideration of the above-described circumstances, an object of the present invention is to provide a solar battery cell such that higher conversion efficiency than ever before is achieved. Additionally, it is an object to provide a solar battery cell such that conversion efficiency of its front surface and conversion efficiency of its rear surface become almost equivalent in a double-sided light-receiving type solar battery cell.

### [Means for Solving the Problems]

In order to attain the above described objects, according to the present invention, there is provided a solar battery cell including: an n-type silicon substrate having a thickness of not less than 100 µm nor more than 250 µm; a p-type diffusion layer formed on a first light-receiving surface being a front surface of the silicon substrate; an n-type diffusion layer formed on a second light-receiving surface being a rear surface of the silicon substrate; an anti-reflection film formed on the p-type diffusion layer and the n-type diffusion layer; a plurality of grid electrodes and a plurality of busbar electrodes that are formed on part of the p-type diffusion layer; and a plurality of grid electrodes and a plurality of busbar electrodes that are formed on part of the n-type diffusion layer, in which the grid electrodes provided on the first light-receiving surface are each formed in a manner that two layers of a first electrode layer and a second electrode layer are stacked in the order from the silicon substrate side, power generation capacity of the first light-receiving surface is equal to or more than 18.5% in terms of conversion efficiency, and conversion efficiency of the second light-receiving surface is equal to or more than 93% of conversion efficiency of the first light-receiving surface.

In the above-described solar battery cell, the thickness of the silicon substrate may also be not less than 100 µm nor more than 210 µm, the grid electrodes provided on the first light-receiving surface and the second light-receiving surface each may also be formed in a manner that two layers of a first electrode layer and a second electrode layer are stacked in the order from the silicon substrate side, and the conversion efficiency of the second light-receiving surface may also be not less than 98% nor more than 102% of the conversion efficiency of the first light-receiving surface.

The number of the busbar electrodes provided on the first light-receiving surface and the number of the busbar electrodes provided on the second light-receiving surface each may also be not less than three nor more than six.

Contact resistance of the first electrode layer with the silicon substrate may also be equal to or less than 5.0 x 10⁻³ Ω•cm².

Specific volume resistivity of the second electrode layer may also be equal to or less than 5.0 x 10⁻⁶ Ω•cm.

A plurality of high-concentration p-type diffusion regions and low-concentration p-type diffusion regions each adjacently located between the high-concentration p-type diffusion regions may also be formed in the p-type diffusion layer, a plurality of high-concentration n-type diffusion regions and low-concentration n-type diffusion regions each adjacently located between the high-concentration n-type diffusion regions may also be formed in the n-type diffusion layer, and the grid electrodes each may also be formed on the plurality of high-concentration p-type diffusion regions and the plurality of high-concentration n-type diffusion regions.

An entirely uniform p-type diffusion region may also be formed in the p-type diffusion layer, and an entirely uniform n-type diffusion region may also be formed in the n-type diffusion layer.

An entirely uniform p-type diffusion region may also be formed in the p-type diffusion layer, a plurality of high-concentration n-type diffusion regions and low-concentration n-type diffusion regions each adjacently located between the high-concentration n-type diffusion regions may also be formed in the n-type diffusion layer, and the grid electrodes each may also be formed on the plurality of high-concentration n-type diffusion regions.

The grid electrodes and the busbar electrodes each may also be formed of either Ag or Ag and aluminum metal.

An insulating film for passivation may also be formed between the p-type diffusion layer and the anti-reflection film, and the insulating film for passivation may also be formed of Al₂O₃ or a thermally oxidized film. Further, an insulating film for passivation may also be formed between the n-type diffusion layer and the anti-reflection film, and the insulating film for passivation may also be formed of SiN or a thermally oxidized film.

A line width of the grid electrodes provided on the first light-receiving surface and the second light-receiving surface may also be not less than 50 µm nor more than 90 µm, and a height of the grid electrodes may also be not less than 15 µm nor more than 50 µm. Incidentally, when the grid electrodes provided on the second light-receiving surface are each composed of a single layer, a line width of the grid electrodes may also be not less than 50 µm nor more than 120 µm, and a height of the grid electrodes may also be not less than 10 µm nor more than 40 µm.

A line width of the grid electrodes provided on the first light-receiving surface may also be not less than 50 µm nor more than 90 µm and a height of the grid electrodes may also be not less than 15 µm nor more than 50 µm, and a line width of the grid electrodes provided on the second light-receiving surface may also be not less than 50 µm nor more than 120 µm and a height of the grid electrodes may also be not less than 10 µm nor more than 40 µm.

Further, according to the present invention, there is provided a method of manufacturing the solar battery cell described above, in which the p-type diffusion layer is formed in such a manner that a single-crystal silicon substrate is thermally treated in an atmosphere of boron tribromide gas being a source gas.

Further, according to the present invention, there is provided a method of manufacturing the solar battery cell described above, in which the p-type diffusion layer is formed in such a manner that liquid or solid containing a boron element is applied or made to adhere on a single-crystal silicon substrate in advance and then is thermally treated.

Further, according to the present invention, there is provided a method of manufacturing the solar battery cell described above, in which the p-type diffusion layer is formed in such a manner that a gas containing a boron element is ion implanted onto a single-crystal silicon substrate.

Further, according to the present invention, there is provided a method of manufacturing the solar battery cell described above, in which the n-type diffusion layer is formed in such a manner that a single-crystal silicon substrate is thermally treated in an atmosphere of phosphorus oxychloride gas being a source gas.

Further, according to the present invention, there is provided a method of manufacturing the solar battery cell described above, in which the n-type diffusion layer is formed in such a manner that liquid or solid containing a phosphorus element is applied or made to adhere on a single-crystal silicon substrate in advance and then is thermally treated.

Further, according to the present invention, there is provided a method of manufacturing the solar battery cell described above, in which the n-type diffusion layer is formed in such a manner that a gas containing a phosphorus element is ion implanted onto a single-crystal silicon substrate.

Further, according to the present invention, there is provided a method of manufacturing the solar battery cell described above, in which the first electrode layer formed on the p-type diffusion layer is formed in such a manner that a conductive paste containing Ag and aluminum metal with a composition containing not less than 1.0 wt% nor more than 5.0 wt% of aluminum metal with respect to Ag is screen printed to be burned.

Further, according to the present invention, there is provided a method of manufacturing the solar battery cell described above, in which the first electrode layer formed on the n-type diffusion layer is formed in such a manner that a conductive paste containing Ag is screen printed to be burned.

Further, according to the present invention, there is provided a method of manufacturing the solar battery cell described above, in which a second electrode layer formed on the first electrode layer is formed in such a manner that a conductive paste containing Ag is screen printed to be burned.

### [Effect of the Invention]

According to the present invention, it is possible to provide a solar battery cell such that making conversion efficiency higher than ever before is achieved. Additionally, there is provided a solar battery cell such that conversion efficiency of its front surface and conversion efficiency of its rear surface become almost equivalent in a double-sided light-receiving type solar battery cell. Specifically, by manufacturing a double-sided light-receiving type solar battery cell with the use of a silicon substrate thinner than ever before, the conversion efficiency can be made higher than ever before and the conversion efficiency of a first light-receiving surface and the conversion efficiency of a second light-receiving surface can be made almost equivalent.

### [Brief Description of the Drawings]

[FIG. 1(a) to FIG. 1(n)] FIG. 1(a) to FIG. 1(n) are explanatory views of steps for manufacturing a solar battery cell.
[FIG. 2(a) and FIG. 2(b)] FIG. 2(a) and FIG. 2(b) are plan views of a solar battery cell A, FIG. 2(a) illustrates a first light-receiving surface, and FIG. 2(b) illustrates a second light-receiving surface.
[FIG. 3] FIG. 3 is a schematic explanatory view of the solar battery cell seen from an obliquely upper side.
[FIG. 4] FIG. 4 graphically illustrates relationships between a substrate thickness of a substrate to be used for manufacture of a solar battery cell and conversion efficiency of the manufactured solar battery cell.
[FIG. 5] FIG. 5 graphically illustrates relationships between a substrate thickness of a substrate and a conversion efficiency ratio (Bifaciality) of the manufactured solar battery cell.
[FIG. 6] FIG. 6 is a graph illustrating relationships between contact resistance and conversion efficiency of a first light-receiving surface where contact resistance of a first electrode layer and the substrate was changed.
[FIG. 7] FIG. 7 is a graph illustrating relationships between an aluminum metal added amount and contact resistance where an added amount of aluminum metal contained in a conductive paste forming the first electrode layers on a p-type diffusion layer was changed.
[FIG. 8(a) and FIG. 8(b)] FIG. 8(a) and FIG. 8(b) are explanatory views of constitution in which the two solar battery cells are connected by using a wiring material, and FIG. 8(a) is a schematic plan view and FIG. 8(b) is a schematic side view.
[FIG. 9] FIG. 9 is a graph illustrating relationships between a line width and a short-circuit current of the cell where the line width of a grid electrode was changed from about 40 µm to 120 µm.
[FIG. 10] FIG. 10 is a graph illustrating relationships between a line width and a fill factor of the cell where the line width of the grid electrode was changed from about 40 µm to 120 µm.
[FIG. 11] FIG. 11 graphically illustrates relationships between the line width of the grid electrode and conversion efficiency.
[FIG. 12] FIG. 12 is a graph illustrating relationships between a height and conversion efficiency of the cell where the height of the grid electrode was changed from about 9 µm to 50 µm.
[FIG. 13] FIG. 13 is a graph illustrating conversion efficiency where the grid electrodes were formed in a single-layer structure and conversion efficiency where the grid electrodes were formed in a two-layer structure.
[FIG. 14] FIG. 14 is a graph illustrating relationships between a thin line width and a conversion efficiency ratio (Bifaciality) where grid electrodes formed on a second light-receiving surface were formed in a single-layer structure and the width of the grid electrode was changed from about 47 µm to 123 µm.
[FIG. 15] FIG. 15 is a graph illustrating relationships between a height and conversion efficiency of the first light-receiving surface where the height of grid electrodes 44 in a single-layer structure formed on the second light-receiving surface was changed from about 7 µm to about 40 µm.
[FIG. 16(a) to FIG. 16(e)] FIG. 16(a) to FIG. 16(e) are explanatory views of a case where boron diffusion and phosphorus diffusion on a substrate are performed simultaneously.

### [Explanation of Codes]

- 3: first light-receiving surface
- 4: second light-receiving surface
- 5: oxide film
- 7: resist film
- 15: high-concentration p-type diffusion region
- 16: low-concentration p-type diffusion region
- 25: high-concentration n-type diffusion region
- 26: low-concentration n-type diffusion region
- 35: anti-reflection film
- 30: first electrode layer
- 42: second electrode layer
- 44: grid electrode
- 45: busbar electrode
- 50: wiring material
- A: solar battery cell
- W: (semiconductor) substrate

### [Mode for Carrying out the Invention]

Hereinafter, an embodiment of the present invention will be described with reference to the drawings. Note that in the description and the drawings, components substantially having the same functions and structures will be denoted by the same reference numerals and symbols and a redundant description thereof will be omitted.

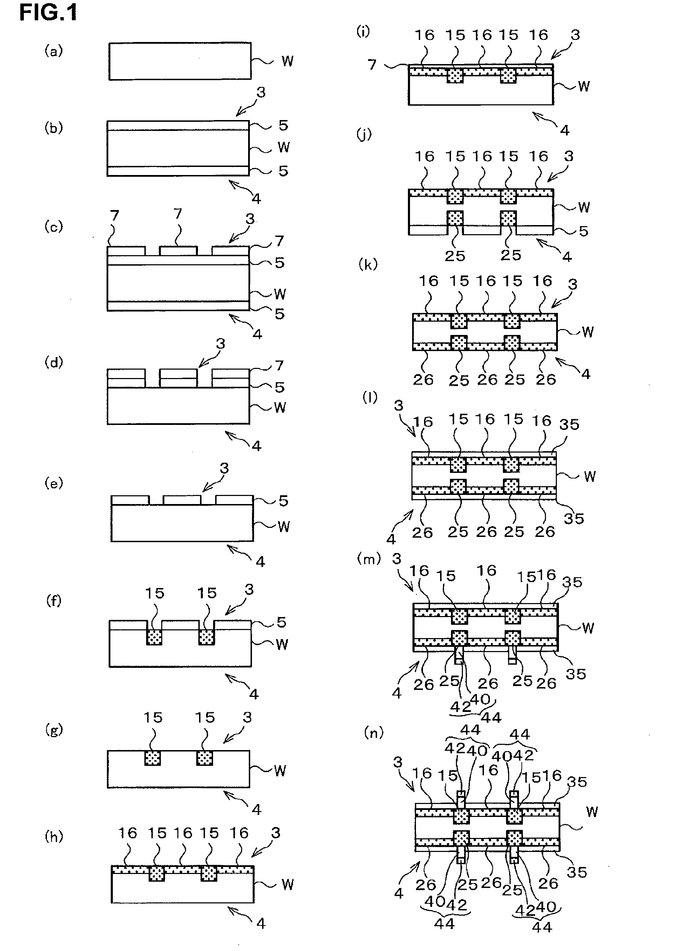

Here, there will be explained manufacturing steps of a solar battery cell A according to the embodiment of the present invention with reference to FIG. 1(a) to FIG. 1(n). FIG. 1(a) to FIG. 1(n) are explanatory views of steps for manufacturing the solar battery cell A according to this embodiment. First, as illustrated in FIG. 1(a), there is prepared an n-type semiconductor silicon substrate W (hereinafter, also simply referred to as a semiconductor substrate W or a substrate W) made of single-crystal silicon and the like that is manufactured by, for example, a CZ method. The substrate W has, for example, a 15.6 cm square size and a 100 to 250 µm thickness. Further, the substrate W has a specific resistance of 1.0 to 14.0 Ω•cm.

Next, the substrate W is immersed in a high-concentration (for example, 10 wt%) sodium hydroxide solution, and thereby a damage layer made during slicing is removed.

Next, a texture structure (an irregularity structure) is formed on the substrate W. The reason why the texture structure is formed is that the solar battery usually has irregularities on its surface, to thereby reduce reflectance for absorption wavelength range of sunlight. As a specific method, the substrate W from which the damage layer has been removed is wet-etched by being immersed in a solution in which isopropyl alcohol is added to the sodium hydroxide solution with a concentration of, for example 2 wt%, and thereby a random texture structure is formed on the surface of the substrate W. The size of each peak of the texture structure is about 0.3 to 20 µm. Incidentally, as a method of forming the random texture structure, acid etching, reactive ion etching, or the like is also usable, for example, instead of the above-described wet etching.

Subsequently, as illustrated in FIG. 1(b), oxide films 5 are formed both on a front surface (hereinafter, also referred to as a first light-receiving surface 3) of the substrate W and a rear surface (hereinafter, also referred to as a second light-receiving surface 4) of the substrate W by a heating treatment at 980°C in an oxygen-containing atmosphere. For example, nitride films or the like (SiNx films or the like) may also be formed instead of the oxide films 5.

Next, as illustrated in FIG. 1(c), a resist film 7 in a predetermined pattern is applied to, for example, a 10 to 30 µm thickness on a front surface of the oxide film 5. Then, as illustrated in FIG. 1(d), with the resist film 7 used as a mask, wet etching using, for example, a 5 wt% HF solution is performed, so that the oxide film 5 is etched to a predetermined pattern. By this etching, the oxide film 5 is etched to the predetermined pattern formed in the resist film 7. Further, at this time, the oxide film 5 formed on the second light-receiving surface 4 is all etched (removed).

Next, as illustrated in FIG. 1(e), the resist film 7 is peeled by an alkaline solution to be removed.

Next, in a diffusion furnace set to 950°C, boron is diffused on exposed portions of the first light-receiving surface 3 of the substrate W in an atmosphere containing boron tribromide (BBr₃) gas, with the oxide film 5 etched to the predetermined pattern being used as a mask, as illustrated in FIG. 1 (f). Consequently, a plurality of high-concentration p-type diffusion regions 15 are formed in an island shape on the first light-receiving surface 3 of the substrate W. Here, sheet resistance of the high-concentration p-type diffusion regions 15 is preferably 20 to 60 Ω/□ (ohm/square). Incidentally, as the method for the boron diffusion, the diffusing method in the atmosphere of the boron tribromide (BBr₃) gas is illustrated as an example but the method is not limited to this and, for example, boron trichloride (BCl₃) gas or boron oxide (B₂O₃) is also usable. Further, for the boron diffusion, a method using BN (boron nitride) as a source, or a method using screen printing, ink jet printing, spin coating, ion implanting, or the like is also adoptable.

Next, as illustrated in FIG. 1(g), the oxide film 5 on the first light-receiving surface 3 is removed by wet etching using, for example, a 5 wt% HF solution. Then, in a diffusion furnace set to 930°C, boron is diffused on the whole first light-receiving surface 3 of the substrate W in an atmosphere containing boron tribromide (BBr₃) gas. Consequently, as illustrated in FIG. 1(h), low-concentration p-type diffusion regions 16 are formed each between the plural high-concentration p-type diffusion regions 15 on the light-receiving surface 3 of the substrate W. Here, boron silicate glass films (not illustrated) are formed both on the front surface and the rear surface of the substrate W. Note that sheet resistance of the low-concentration p-type diffusion regions 16 is preferably 30 to 150 Ω/□.

Subsequently, as illustrated in FIG. 1 (i), a resist film 7 is printed on the first light-receiving surface 3 by a screen printing method and drying of the substrate W is performed in a 180°C hot-air drying furnace. By the printing and drying of the resist film 7, the boron silicate glass film (not illustrated) formed on the first light-receiving surface 3 of the substrate W is protected. As the resist film 7, a material having hydrofluoric acid resistance and nitric acid resistance and peelable by an alkaline solution is preferably used.

Next, the substrate W on whose first light-receiving surface 3 the resist film 7 is printed (after the drying) is immersed in, for example, a fluoro nitric acid solution or a hydrofluoric acid solution, and thereby the boron silicate glass film (not illustrated) formed on the other surface (second light-receiving surface 4) of the substrate W on which the resist film 7 is not printed and high-concentration p-type diffusion regions formed by out-diffusion are removed. Then, the resist film 7 is removed with the use of, for example, a sodium hydroxide solution, and the substrate W is washed and dried.

Next, in a diffusion furnace set to 870°C, in an atmosphere containing phosphorus oxychloride (POCl₃) gas, as illustrated in FIG. 1(j), an oxide film 5 etched to a predetermined pattern is formed on the second light-receiving surface 4 of the substrate W as a mask by the same method as that of the above-described boron diffusion performed on the first light-receiving surface 3. Then, phosphorus is diffused on exposed portions of the second light-receiving surface 4 of the substrate W. In the formation of the oxide film 5 at this time, the oxide film 5 and a resist film 7 are formed into a predetermined pattern as in the above-described boron diffusion and diffusion regions are formed, but methods for the formation of the oxide film 5 and the resist film 7, the removal of the oxide film 5 and the resist film 7 after the phosphorus diffusion, and the like are the same as those explained in FIG. 1(b) to FIG. 1(g), and therefore, a description thereof will be omitted here.

Consequently, a plurality of high-concentration n-type diffusion regions 25 are formed in an island shape on the second light-receiving surface 4 of the substrate W as illustrated in FIG. 1(j). Here, sheet resistance of the high-concentration n-type diffusion regions 25 is preferably 20 to 60 Ω/□. Further, the phosphorus diffusion may also be performed by an ink jet printing method, spraying, spin coating, a laser doping method, or a method using ion implantation or the like.

Then, in a diffusion furnace set to 830°C, phosphorus is diffused on the whole second light-receiving surface 4 of the substrate W in an atmosphere containing phosphorus oxychloride (POCl₃) gas. Consequently, as illustrated in FIG. 1(k), low-concentration n-type diffusion regions 26 are formed each between the plural high-concentration n-type diffusion regions 25 on the second light-receiving surface 4 of the substrate W. At this time, phosphorus silicate glass films (not illustrated) are formed both on the first light-receiving surface 3 and the second light-receiving surface 4 of the substrate W. Note that sheet resistance of the low-concentration n-type diffusion regions 26 is preferably 30 to 150 Ω/□.

Next, PN junction separation in a peripheral portion of the substrate W is performed by a plasma etcher, and the boron silicate glass films (not illustrated) and the phosphorus silicate glass films (not illustrated) that are formed on the first light-receiving surface 3 and the second light-receiving surface 4 of the substrate W in the above-described steps of the boron diffusion, the phosphorus diffusion, and the like are removed by etching with the use of a hydrofluoric acid solution. Thereafter, as illustrated in FIG. 1(1), anti-reflection films 35 being, for example, nitride films (SiNx films) are formed on the whole first light-receiving surface 3 and second light-receiving surface 4 by a plasma CVD apparatus. Here, as other kinds of the anti-reflection films 35, there can be cited, for example, titanium dioxide films, zinc oxide films, tin oxide films, and the like, which can be used as a substitute. Further, it is described that a direct plasma CVD method by the above-described plasma CVD apparatus is used for the formation of the anti-reflection films 35, but a remote plasma CVD method, a coating method, a vacuum vapor deposition method, or the like may also be used, for example. However, from an economic point of view, it is the most suitable to form the nitride films by the plasma CVD method. Further, when films such as, for example, magnesium difluoride films whose refractive index is 1 to 2 are formed on the anti-reflection films 35 in order to make the total reflectance the smallest, a reduction in reflectance is promoted and density of generated current becomes high. Further, insulating films for passivation may also be formed between the substrate W and the anti-reflection films 35. Note that this insulating film for passivation may also be Al₂O₃, a thermally oxidized film, or SiN.

Subsequently, as illustrated in FIG. 1(m), a conductive paste containing, for example, Ag is printed in a predetermined pattern on surfaces of the high-concentration n-type diffusion regions 25 on the second light-receiving surface 4 of the substrate W (lower surfaces in the drawing) by using a screen printer and then is dried to form first electrode layers 40. Then, second electrode layers 42 formed of a conductive paste containing, for example, Ag are printed by screen printing on surfaces of the first electrode layers 40 formed on the high-concentration n-type diffusion regions 25 (lower surfaces in the drawing) to be dried. Stacks each composed of the first electrode layer 40 and the second electrode layer 42 serve as grid electrodes 44. Incidentally, the explanation is made here based on the fact that the screen printing method is used as the method of forming the electrodes, but the method of forming the grid electrodes 44 and a method of forming busbar electrodes 45 may also be a plating method, an ink-jet method, or the like. Detailed constitution of the grid electrodes 44 formed as above will be described later with reference to the drawings and the like.

Further, the busbar electrodes 45 are also formed by the same method as that of the above-described grid electrodes 44, and the busbar electrodes 45 are also each composed of a first electrode layer and a second electrode layer formed of a conductive paste containing Ag, which is not illustrated in FIG. 1(m). Incidentally, the busbar electrodes 45 do not each have to have a two-layer structure, and may also be composed of not the first electrode layer 40 but only the second electrode layer 42, for example.

Next, as illustrated in FIG. 1(n), a conductive paste containing, for example, Ag and aluminum metal is printed in a predetermined pattern on surfaces of the high-concentration p-type diffusion regions 15 on the first light-receiving surface 3 (upper surfaces in the drawing) as in the above-described case illustrated in FIG. 1(m) and then is dried to form first electrode layers 40. Then, second electrode layers 42 formed of a conductive paste containing, for example, Ag are printed by screen printing on surfaces of the first electrode layers 40 formed on the high-concentration p-type diffusion regions 15 (upper surfaces in the drawing) to be dried. Stacks each composed of the first electrode layer 40 and the second electrode layer 42 serve as grid electrodes 44.

Here, as has been explained with reference to FIG. 1(m) and FIG. 1(n), this embodiment is set that the grid electrodes 44 are each composed of two layers of the first electrode layer 40 and the second electrode layer 42 both on the first light-receiving surface 3 and the second light-receiving surface 4, but it is also possible that the grid electrodes 44 in a two-layer structure are staked only on the first light-receiving surface 3 and grid electrodes 44 in a single layer structure (formed of a conductive paste in a single layer) are formed on the second light-receiving surface 4, for example.

The first electrode layers 40 are preferably formed of, for example, a material lower in contact resistance with the silicon substrate (semiconductor substrate W) and higher in adhesive strength with the silicon substrate (semiconductor substrate W) than the second electrode layers 42. Specifically, the contact resistance of the first electrode layers 40 formed on the surfaces of the high-concentration p-type diffusion regions 15 with the silicon substrate is preferably equal to or less than 5.0 x 10⁻³ Ω•cm². As a method of measuring this contact resistance, a TLM (Transmission Line Model) method is used. When the conductive paste containing Ag and aluminum metal is used as the first electrode layers 40, the conductive paste preferably has a composition containing 1.0 to 5.0 wt% of aluminum metal with respect to the content of Ag as a compounding ratio of the conductive paste.

On the other hand, the second electrode layers 42 are preferably lower in, for example, specific volume resistivity of the silicon substrate and more excellent in conductivity than the first electrode layers 40. Specifically, the specific volume resistivity (line resistance) of the second electrode layers 42 is preferably equal to or less than 5.0 x 10⁻⁶ Ω•cm. As the second electrode layers 42, the conductive paste containing Ag is preferably used.

A purpose of the grid electrodes 44 is to efficiently collect electric power generated in the substrate W to the busbar electrodes 45. For this purpose, it is desirable that the grid electrodes 44 are each made into a shape effective for decreasing electric resistance by increasing its height to make its cross-sectional area large, and contact resistance of interfaces where the grid electrodes 44 and the substrate W are in contact with each other is low, and specific volume resistivity of the grid electrodes 44 is low. Thus, in this embodiment, as described above, the grid electrodes 44 are each made as a two-layer structure composed of the first electrode layer 40 and the second electrode layer 42 so as to obtain a sufficient height, the first electrode layers 40 disposed at positions where they are in contact with the substrate W are made low in contact resistance with the substrate W, and the second electrode layers 42 are made lower in specific volume resistivity than the first electrode layers 40.

Incidentally, in the solar battery cell A according to this embodiment, it is also possible that the electrode layers (the first electrode layer 40 and the second electrode layer 42) constituting the grid electrode 44 on the first light-receiving surface 3 and the electrode layers (the first electrode layer 40 and the second electrode layer 42) constituting the grid electrode 44 on the second light-receiving surface 4 are made different in composition, and as one example, as described above, the conductive paste containing Ag and aluminum metal is preferably used as the first electrode layers 40 and the conductive paste containing Ag is preferably used as the second electrode layers 42 on the first light-receiving surface 3. Then, the conductive paste containing Ag is preferably used as the first electrode layers 40 and the second electrode layers 42 on the second light-receiving surface 4. This is because when aluminum metal is doped with respect to an n-type diffusion layer, a p+layer is formed to cause a risk of a decrease in conversion efficiency of the solar battery cell A.

Then, the grid electrodes 44 are formed on the high-concentration p-type diffusion regions 15 on the first light-receiving surface 3 and on the high-concentration n-type diffusion regions 25 on the second light-receiving surface 4 by the above-described method to be burned, and thereby the solar battery cell A is fabricated.

Incidentally, in the above-described steps, the step of PN junction separation by a plasma etcher is not performed, but PN junction separation using a laser may also be performed after the electrodes are burned.

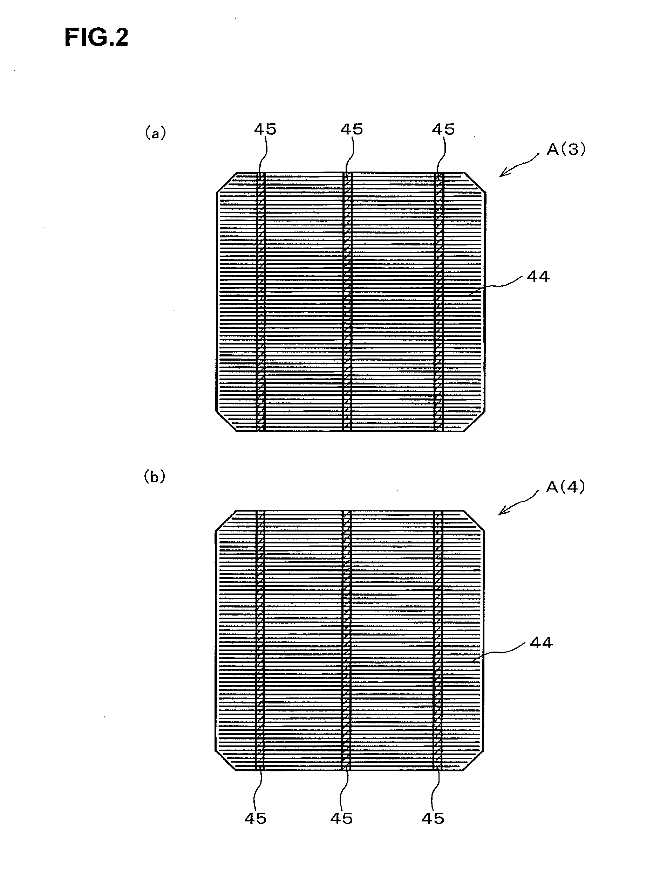

A detailed structure of the solar battery cell A fabricated by the above-described method with reference to FIG. 1(a) to FIG. 1(n) will be explained with reference to FIG. 2(a) and FIG. 2(b) to FIG. 4 below. FIG. 2(a) and FIG. 2(b) are plan views of the solar battery cell A, and FIG. 2(a) illustrates the first light-receiving surface 3 (front surface of the solar battery cell A) and FIG. 2(b) illustrates the second light-receiving surface 4 (rear surface of the solar battery cell A). As illustrated in FIG. 2(a) and FIG. 2(b), the solar battery cell A has a substantially square shape in a planar view, and has a 15.6 cm square size, for example.

As illustrated in FIG. 2(a), on the first light-receiving surface 3, three pieces of the busbar electrodes 45 are formed parallel to each other, at regular intervals, and in a predetermined direction (a direction parallel to one side of the square shape, for example). Further, on the first light-receiving surface 3, plural pieces (for example, about 70 to 80 pieces) of the grid electrodes 44 are formed at regular intervals in a direction perpendicular to the busbar electrodes 45.

Further, as illustrated in FIG. 2(b), similarly to the first light-receiving surface 3, also on the second light-receiving surface 4, three pieces of the busbar electrodes 45 are formed parallel to each other, at regular intervals, and in a predetermined direction, and plural pieces (for example, about 70 to 80 pieces) of the grid electrodes 44 are formed at regular intervals in a direction perpendicular to the busbar electrodes 45. The grid electrodes 44 serve as electrodes used for collecting electric power generated in the solar battery cell A to the busbar electrodes 45, and further the busbar electrodes 45 serve as electrodes used for collecting electric power from the grid electrodes 44. That is, as illustrated in FIG. 2(a) and FIG. 2(b), the grid electrodes 44 and the busbar electrodes 45 are each electrically conducted.

As illustrated in FIG. 2(a) and FIG. 2(b), the first light-receiving surface 3 being the front surface of the solar battery cell and the second light-receiving surface 4 being the rear surface of the solar battery cell are constituted in the same manner and on the both surfaces, the busbar electrodes 45 and the grid electrodes 44 are formed, and thereby a structure in which the first light-receiving surface 3 and the second light-receiving surface 4 are both established as a light-receiving surface with a power generation capacity is made. Here, the number of busbar electrodes 45 is not limited to three, and only needs to be a number enabling sufficient power collection from the grid electrodes, and is preferred to be three to five, for example. Further, it is sufficient if the number of grid electrodes is also determined appropriately according to the power generation capacity. Incidentally, the reason why the number of busbar electrodes 45 is preferably set to three will be described later.

Incidentally, the solar battery element described in Patent Document 1 is a single-sided light-receiving type and has a rear surface thereof covered with an aluminum paste, but the structure of the solar battery cell A according to this embodiment is a double-sided light-receiving type in which the grid electrodes 44 are disposed both on the first light-receiving surface 3 and the second light-receiving surface 4 as illustrated in FIG. 2(a) and FIG. 2(b), and is a structure in which the first light-receiving surface 3 and the second light-receiving surface 4 are not covered with an aluminum paste, to thus be different from that of Patent Document 1, and properties of the solar battery cell A are also largely different.

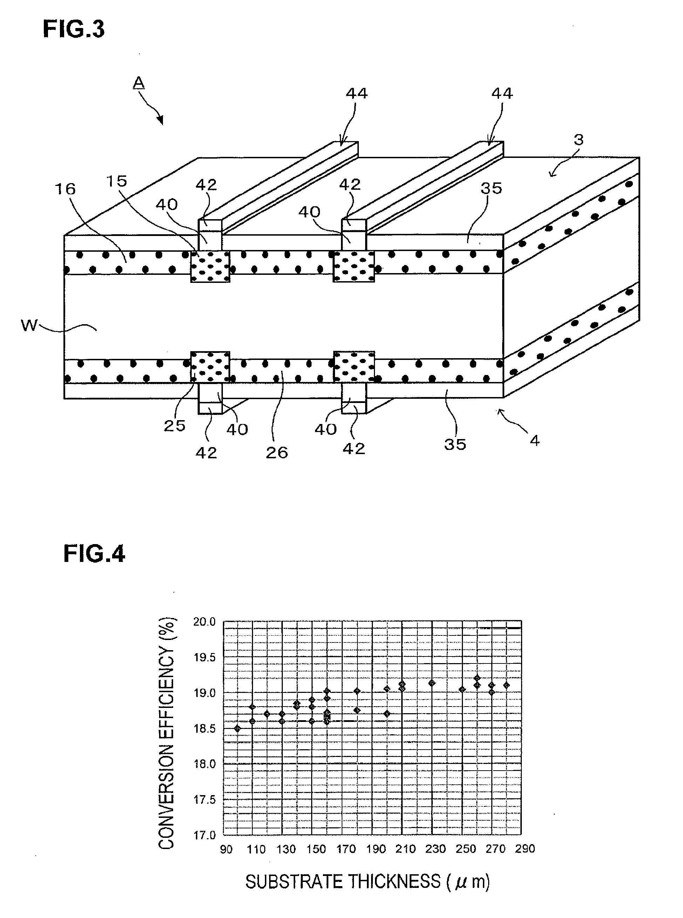

Further, FIG. 3 is a schematic explanatory view of the solar battery cell A seen from an obliquely upper side. Note that FIG. 3 illustrates part of the solar battery cell A where the grid electrodes 44 are formed in an enlarged manner, and also schematically illustrates a cross section of the solar battery cell A.

As illustrated in FIG. 3, in the solar battery cell A according to this embodiment, the high-concentration p-type diffusion regions 15 are disposed on the first light-receiving surface 3 of the semiconductor substrate W, and the grid electrodes 44 each composed of the two layers (the first electrode layer 40 and the second electrode layer 42) are formed directly on upper surfaces of the high-concentration p-type diffusion regions 15. Further, the high-concentration n-type diffusion regions 25 are disposed on the second light-receiving surface 4, and the grid electrodes 44 each composed of the two layers are formed directly on lower surfaces of the high-concentration n-type diffusion regions 25 in the above-described steps.

When manufacturing the solar battery cell A with the structure illustrated in FIG. 2(a) and FIG. 2(b) and FIG. 3, in this embodiment, an n-type silicon substrate having a thickness of 100 to 250 µm, for example is used as the semiconductor substrate W, and further the grid electrodes 44 formed at least on the first light-receiving surface 3 are each formed to have a two-layer structure in which the first electrode layer 40 and the second electrode layer 42 are stacked. Applying such a constitution makes it possible to manufacture the solar battery cell A provided with desired performance that conversion efficiency on the first light-receiving surface 3 is equal to or more than 18.5% and conversion efficiency on the second light-receiving surface 4 is equal to or more than 93% of the conversion efficiency on the first light-receiving surface 3.

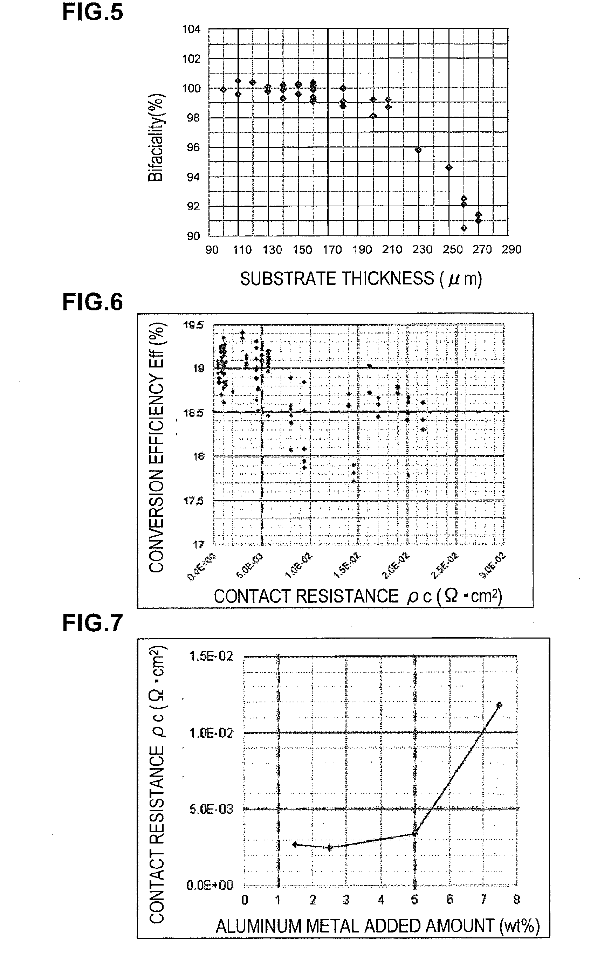

There will be examined relationships between the thickness of the semiconductor substrate W (n-type silicon substrate) to be used when the solar battery cell A according to this embodiment is manufactured and conversion efficiency or a conversion efficiency ratio (Bifaciality) below with reference to FIG. 4 and FIG. 5.

FIG. 4 graphically illustrates relationships between the substrate thickness of the substrate W to be used for the manufacture of the solar battery cell A and the conversion efficiency of the first light-receiving surface 3 of the manufactured solar battery cell A. The data illustrated in FIG. 4 are obtained by manufacturing solar battery cells A with the use of substrates W having various thicknesses (100 to 280 µm) and measuring each conversion efficiency of first light-receiving surfaces 3 in respective cases. Incidentally, the basic structure of the solar battery cells A where the data illustrated in FIG. 4 are measured is the structure according to this embodiment (structure illustrated in FIG. 1(a) to FIG. 1(n) to FIG. 3), but for both the first light-receiving surface 3 and the second light-receiving surface 4, ones each manufactured to have a uniform diffusion structure are used.

As illustrated in FIG. 4, when the thickness of the substrate W is 100 µm or more, the conversion efficiency of the first light-receiving surface 3 is equal to or more than 18.5%. Here, it is found from the result obtained in FIG. 4 that the thickness of the substrate W only needs to be 100 µm or more, but the upper limit value of the thickness of the substrate W is not determined specifically.

Further, FIG. 5 graphically illustrates relationships between the substrate thickness of the substrate W and a conversion efficiency ratio (Bifaciality: ratio of conversion efficiency of the first light-receiving surface 3 and that of the second light-receiving surface 4) of the solar battery cell A. Incidentally, the data illustrated in FIG. 5 are obtained by manufacturing solar battery cells A each having the same structure as that of the solar battery cells A set as measuring objects in FIG. 4 with the use of substrates W having various thicknesses (100 to 280 µm) and measuring each conversion efficiency ratio in respective cases.

As illustrated in FIG. 5, when the thickness of the substrate W is 250 µm or less, the conversion efficiency ratio is about 93% or more. Thus, it is found from the result obtained in FIG. 5 that the thickness of the substrate W only needs to be 250 µm or less in order to obtain about 93% or more of the conversion efficiency ratio. This is because thinning the thickness of the substrate W makes a distance where carriers generated inside the substrate of the solar battery cell A move to a PN junction portion short, and thereby the conversion efficiency of the second light-receiving surface 4 improves to make it possible to obtain the conversion efficiency ratio of the first light-receiving surface 3 and the second light-receiving surface 4 close to 100%.

Further, according to FIG. 5, when the thickness of the substrate W is 210 µm or less, the conversion efficiency ratio is about not less than 98% nor more than 102%. From this, it is found that setting the thickness of the substrate W to 210 µm or less enables the conversion efficiency of the first light-receiving surface 3 and the conversion efficiency of the second light-receiving surface 4 to become a value quite close to the equivalence.

From the above, it is found from the findings explained with reference to FIG. 4 and FIG. 5 that when manufacturing the solar battery cell A according to this embodiment, setting the thickness of the substrate W to not less than 100 µm nor more than 250 µm makes it possible to make the conversion efficiency of the first light-receiving surface 3 be equal to or more than 1.85% and to make the conversion efficiency of the second light-receiving surface 4 be equal to or more than 93% of the conversion efficiency of the first light-receiving surface 3. Further, setting the thickness of the substrate W to not less than 100 µm nor more than 210 µm enables the conversion efficiency ratio to be closer to 100%, (which is about not less than 98% nor more than 102% specifically). That is, in a double-sided light-receiving type solar battery cell, higher conversion efficiency than ever before is achieved, and additionally a solar battery cell such that the conversion efficiency of a front surface (the first light-receiving surface 3) and the conversion efficiency of a rear surface (the second light-receiving surface 4) become almost equivalent can be fabricated.

Next, there will be examined relationships between contact resistance of the first electrode layers 40 with the high-concentration p-type diffusion regions 15 or the low-concentration p-type diffusion regions 16 (namely, the front surface of the first light-receiving surface side of the silicon substrate W) and conversion efficiency of the solar battery cell A with reference to FIG. 6 and FIG. 7 on the occasion of manufacture of the solar battery cell A according to this embodiment.

FIG. 6 is a graph illustrating relationships between the contact resistance and the conversion efficiency of the first light-receiving surface 3 where the contact resistance between the first electrode layers 40 and the substrate W was changed. The data illustrated in FIG. 6 are obtained by measuring the conversion efficiency of the first light-receiving surface 3 in respective cases (respective solar battery cells) where the contact resistance of the first electrode layers 40 and the front surface of the substrate W (surface where the high-concentration p-type diffusion regions 15 or the low-concentration p-type diffusion regions 16 are formed: first light-receiving surface 3) was changed.

As illustrated in FIG. 6, when the contact resistance of the first electrode layers 40 and the front surface of the substrate W is equal to or less than 5.0 x 10⁻³ Ω•cm², the conversion efficiency of the first light-receiving surface 3 becomes equal to or more than 18.5% securely. On the other hand, when the contact resistance of the first electrode layers 40 and the front surface of the substrate W is greater than 5.0 x 10⁻³ Ω•cm², there are cases that the conversion efficiency of the first light-receiving surface 3 is 18.5% or more and 18.5% or less, so that the solar battery cell A with the first light-receiving surface 3 whose conversion efficiency is equal to or more than 18.5% cannot necessarily be obtained. That is, in order to stably produce the solar battery cell A with the first light-receiving surface 3 whose conversion efficiency is equal to or more than 18.5%, the contact resistance of the first electrode layers 40 and the front surface of the substrate W needs to be equal to or less than 5.0 x 10⁻³ Ω•cm².

Further, FIG. 7 is a graph illustrating relationships between an aluminum metal added amount and contact resistance where an added amount of aluminum metal contained in the conductive paste forming the first electrode layers 40 formed on the first light-receiving surface 3 was changed. The.data illustrated in FIG. 7 are obtained by measuring the contact resistance between the first electrode layers 40 and the substrate W in respective cases (respective solar battery cells) where an added amount of aluminum metal contained in the conductive paste forming the first electrode layers 40 formed on the first light-receiving surface 3 was changed.

As illustrated in FIG. 7, when the added amount of aluminum metal contained in the conductive paste forming the first electrode layers 40 formed on the first light-receiving surface 3 is 1.0 wt% to 5.0 wt%, the contact resistance between the first electrode layers 40 and the substrate W becomes equal to or less than 5.0 x 10⁻³ Ω•cm² securely. On the other hand, when the aluminum metal added amount is greater than 5.0 wt%, the contact resistance between the first electrode layers 40 and the substrate W becomes greater than 5.0 x 10⁻³ Ω•cm². That is, in order to securely make the contact resistance between the first electrode layers 40 and the substrate W become equal to or less than 5.0 x 10⁻³ Ω•cm², the added amount of aluminum metal contained in the conductive paste forming the first electrode layers 40 needs to be 1.0 wt% to 5.0 wt%.

It is desirable from the findings explained with reference to FIG. 6 and FIG. 7 that the conductive paste forming the first electrode layers 40 formed on the first light-receiving surface 3 is one with the aluminum metal added amount set to 1.0 wt% to 5.0 wt% with respect to Ag on the occasion of manufacture of the solar battery cell A according to this embodiment. This makes the contact resistance between the first electrode layers 40 and the substrate W (first light-receiving surface 3) become equal to or less than 5.0 x 10⁻³ Ω•cm² securely, and the solar battery cell A with the first light-receiving surface 3 whose conversion efficiency is equal to or more than 18.5% can be manufactured stably.

Next, there will be examined relationship between specific volume resistivity of the second electrode layers 42 and conversion efficiency of the solar battery cell A in the solar battery cell A according to this embodiment with reference to Table 1. Table 1 illustrated below illustrates results obtained by measuring conversion efficiency of the solar battery cell A according to this embodiment and specific volume resistivity of the second electrode layers 42. Incidentally, in Table 1, measurements were performed on five patterns of solar battery cells A (Cell No. 1 to 5).

**Table 1**

| CELL No. | CONVERSION EFFICIENCY % | SPECIFIC RESISTANCE Ω·cm |
|---|---|---|
| 1 | 19.40 | 2.20E-06 |
| 2 | 19.23 | 2.41E-06 |
| 3 | 19.01 | 2.52E-06 |
| 4 | 18.88 | 2.71E-06 |
| 5 | 19.04 | 3.67E-06 |

It is found from the measurement results illustrated in Table 1 that when the specific volume resistivity of the second electrode layers 42 is equal to or less than 5.0 x 10⁻⁶ Ω•cm, the solar battery cell A whose conversion efficiency is equal to or more than 18.5% can be obtained.

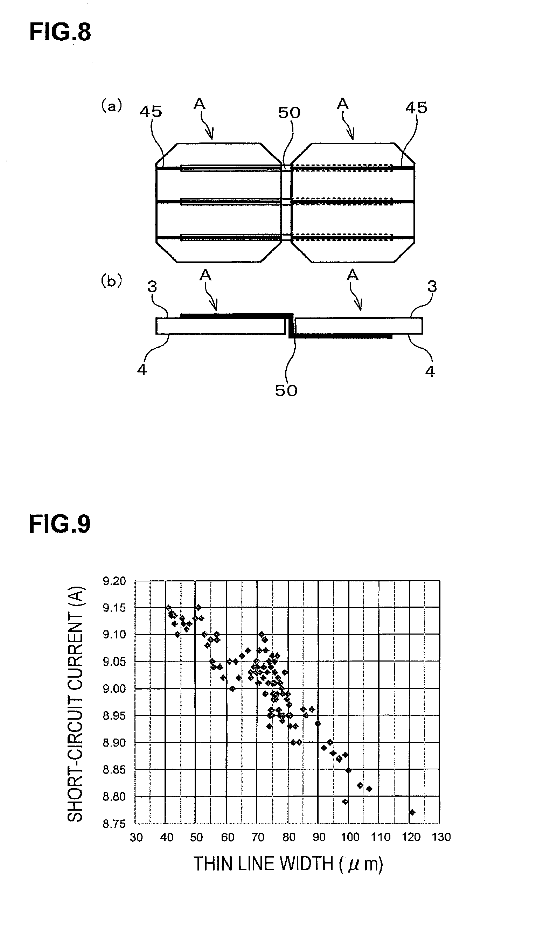

On the other hand, the solar battery cell A is known that when actually constituting a solar battery product (solar battery module), the busbar electrodes 45 of the plural solar battery cells A are connected by a wiring material such as a copper wire coated with, for example, solder and electric power generated in the respective cells is collected by these wiring materials. FIG. 8(a) and FIG. 8(b) are explanatory views of constitution in which the two solar battery cells A are connected by using a wiring material 50, and FIG. 8(a) is a schematic plan view and FIG. 8(b) is a schematic side view.

When the solar battery cells A are connected to each other in the constitution illustrated in FIG. 8(a) and FIG. 8(b), a method of adding heat to the wiring materials 50 and attaching the wiring materials 50 to the busbar electrodes 45 on the respective cells by deposition (for example, soldering) is employed. However, by the addition of heat to the wiring materials 50 being, for example, copper wires coated with solder, or the like, the wiring material 50 are thermally expanded, and when the wiring materials 50 are cooled thereafter, by contraction of the wiring materials 50, stress occurs in connected portions of the respective cells and the like inside the solar battery cells A. This internal stress is likely to cause cracks or the like of the solar battery cells A, to thus be required to be reduced as much as possible. Incidentally, FIG. 8(a) and FIG. 8(b) illustrate, as an example, the constitution such that the wiring materials 50 connect the busbar electrodes 45 on the front surface (first light-receiving surface 3) of one of the solar battery cells A and the busbar electrodes 45 on the rear surface (second light-receiving surface 4) of the other of the solar battery cells A.

In the solar battery cell A according to this embodiment, the thickness of the substrate W to be used is particularly thinned, which is not less than 100 µm nor more than 250 µm or not less than 100 µm nor more than 210 µm, so that cracks are likely to be caused by the internal stress in the above-described connected portions of the cells and the like. In order to avoid the internal stress in the connected portions of the cells and the like, for example, a method of thinning the wiring materials 50 is considered, but when the wiring materials 50 are thinned, a series resistance value of the wiring materials 50 increases to cause a problem that the capacity to collect electric power from the busbar electrodes 45 decreases.

Thus, the present inventors thin the wiring materials 50 and set the number of busbar electrodes 45 to a suitable number, to thereby ensure a sufficient capacity to collect electric power and set the suitable number of busbar electrodes 45 to not less than three nor more than six. The number of busbar electrodes 45 is desired to be three in particular, and there will be explained the reason why the number of busbar electrodes 45 is desirably set to three below with reference to Table 2 and Table 3.

Table 2 illustrates, in the solar battery cell A according to this embodiment, conditions (copper thickness, width, and total cross-sectional area) of the wiring materials 50 being copper wires in the case when the number of busbar electrodes 45 is set to two without changing the other constitution and conditions of the wiring materials 50 being copper wires in the case when the number of busbar electrodes 45 is set to three without changing the other constitution. Incidentally, in Table 2, digitization of the internal stress is difficult, so that the wiring materials 50 are attached only to one surface of the cell and according to magnitude of warpage of the cell at that time, the internal stress is evaluated.

**Table 2**

| BUSBAR NUMBER | WIRING MATERIAL | | | WARPAGE (mm) |
|---|---|---|---|---|
| | COPPER THICKNESS t (mm) | WIDTH w (mm) | TOTAL CROSS-SECTIONAL AREA A (mm²) | |
| 2 | 0.3 | 1.5 | 0.9 | 2 |
| 3 | 0.2 | 1.5 | 0.9 | 1 |

Further, Table 3 illustrates a cracked cell number and a crack percentage in the cases when the number of busbar electrodes 45 is two and three, which is illustrated in Table 2, in three 60-cells serially-connected modules (module 1, module 2, and module 3 in the table) manufactured by attaching work of the wiring materials 50.

**Table 3**

| BUSBAR NUMBER | 60-CELLS SERIALLY-CONNECTED MODULE | | | CRACK PERCENTAGE |
|---|---|---|---|---|
| | MODULE 1 CRACKED CELL NUMBER | MODULE 2 CRACKED CELL NUMBER | MODULE 3 CRACKED CELL NUMBER | |
| 2 | 3 | 5 | 4 | 6.7% |
| 3 | 1 | 0 | 1 | 1.1% |

It is found from the descriptions of Table 2 and Table 3 that the internal stress to occur by thermal contraction during the wiring materials 50 being attached is smaller and the cell crack percentage is lower when the number of busbar electrodes 45 is three than when the number of busbar electrodes 45 is two. Thus, the number of busbar electrodes 45 formed on the solar battery cell A is desirably three. Incidentally, also when the number of busbar electrodes 45 to be formed is set to four or more, the occurrence of internal stress is suppressed and the crack percentage becomes a low value, but from the aspect of manufacturing cost of the solar battery cell and facility cost, the number of busbar electrodes 45 is preferably about three to six, and even when seven or more of the busbar electrodes 45 are formed, the capacity to collect electric power and the like are hardly different from those when the number of busbar electrodes 45 is three to six.

Further, the point that the grid electrodes 44 are each constituted in a two-layer structure in the solar battery cell A according to this embodiment has been described above, but hereinafter, specific dimensions of the suitable grid electrode 44 will be explained with reference to FIG. 9 to FIG. 12. Incidentally, measurement data described in FIG. 9 to FIG. 12 below are measurement results of the case when the grid electrodes 44 in a two-layer structure are formed both on the first light-receiving surface 3 and the second light-receiving surface 4 with a pitch of 2.0 mm in the solar battery cell A.

FIG. 9 is a graph illustrating relationships between a line width and a short-circuit current of the first light-receiving surface 3 of the cell where a line width (thin line width) of the grid electrode 44 in a two-layer structure was changed from about 40 µm to 120 µm in the solar battery cell A according to this embodiment. As illustrated in FIG. 9, as the line width of the grid electrode 44 becomes thicker, a light-receiving area of the solar battery cell A decreases, so that a short-circuit current value of the first light-receiving surface 3 decreases.

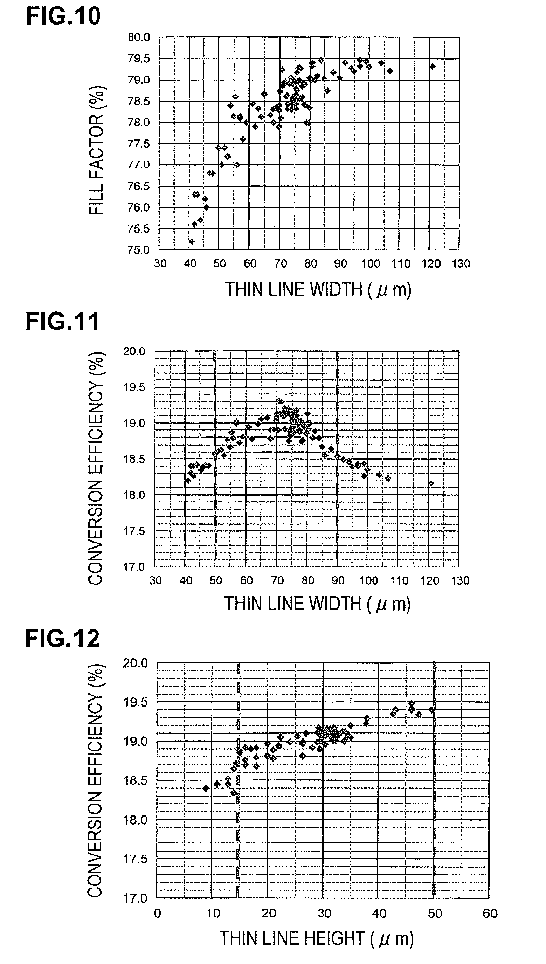

Further, FIG. 10 is a graph illustrating relationships between a line width and a fill factor of the first light-receiving surface 3 of the cell where a line width (thin line width) of the grid electrode 44 in a two-layer structure was changed from about 40 µm to 120 µm in the solar battery cell A according to this embodiment. As illustrated in FIG. 10, as the line width of the grid electrode 44 becomes thicker, a cross sectional area of the grid electrode increases, so that a resistance value decreases and the fill factor of the first light-receiving surface 3 improves.

Further, FIG. 11 graphically illustrates relationships between a line width of the grid electrode 44 and conversion efficiency of the first light-receiving surface 3. As illustrated in FIG. 11, when the line width of the grid electrode 44 is not less than 50 µm nor more than 90 µm, 18.5% or more of the conversion efficiency of the first light-receiving surface 3 is achieved. Thus, in the solar battery cell A according to this embodiment, the grid electrodes 44 are each desirably formed to have a line width of not less than 50 µm nor more than 90 µm. Incidentally, it is also possible that only the grid electrodes 44 formed on the first light-receiving surface 3 are formed as a two-layer structure and the grid electrodes 44 formed on the second light-receiving surface 4 are formed as a single layer.

Further, FIG. 12 is a graph illustrating relationships between a height and conversion efficiency of the first light-receiving surface 3 of the cell where a height (thin line height) of the grid electrode 44 in a two-layer structure was changed from about 9 µm to 50 µm in the solar battery cell A according to this embodiment. As illustrated in FIG. 12, when the height of the grid electrode 44 is not less than 15 µm nor more than 50 µm, 18.5% or more of the conversion efficiency of the first light-receiving surface 3 is achieved. Thus, in the solar battery cell A according to this embodiment, the grid electrodes 44 are each desirably formed to have a height of not less than 15 µm nor more than 50 µm.

As has been explained with reference to FIG. 9 to FIG. 12 above, the specific dimensions of the grid electrode 44 formed on the solar battery cell A according to this embodiment are desired that the line width is not less than 50 µm nor more than 90 µm and the height is not less than 15 µm nor more than 50 µm.

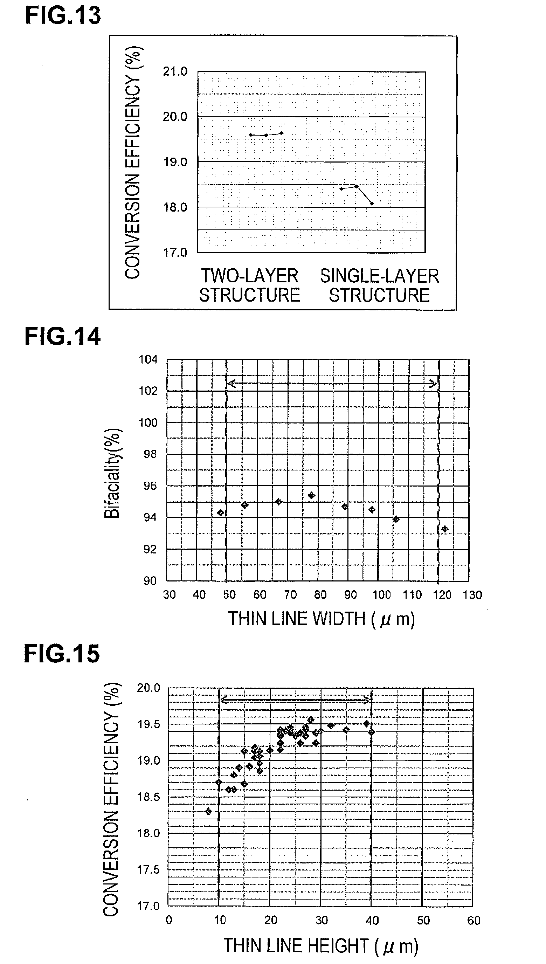

Further, FIG. 13 is a graph illustrating conversion efficiency of the first light-receiving surface 3 where the grid electrodes 44 were formed in a single-layer structure and conversion efficiency of the first light-receiving surface 3 where the grid electrodes 44 were formed in a two-layer structure in the solar battery cell A according to this embodiment. As illustrated in FIG. 13, the conversion efficiency is about 18.0 to 18.5% when the grid electrodes 44 are formed in a single-layer structure, while the conversion efficiency is about 19.5% when the grid electrodes 44 are formed in a two-layer structure. It is found from this that the grid electrodes 44 are formed in a two-layer structure, thereby making it possible to increase the conversion efficiency of the first light-receiving surface 3 of the solar battery cell A.

Next, there will be examined specific dimensions of the grid electrode 44 in a single-layer structure of the case when, of the solar battery cell A, the grid electrodes 44 in a two-layer structure are formed on the first light-receiving surface 3 and the grid electrodes 44 in a single-layer structure are formed on the second light-receiving surface 4. FIG. 14 is a graph illustrating relationships between a thin line width and a conversion efficiency ratio (Bifaciality: a ratio of conversion efficiency of the first light-receiving surface 3 and that of the second light-receiving surface 4) where, in the solar battery cell A, the grid electrodes 44 formed on the second light-receiving surface 4 were formed in a single-layer structure and the line width (thin line width) of the grid electrode was changed from about 47 µm to 123 µm.

As illustrated in FIG. 14, when the line width of the grid electrode 44 in a single-layer structure is not less than 50 µm nor more than 120 µm, 93% or more of the conversion efficiency ratio is achieved. Thus, when the grid electrodes 44 in a single-layer structure are formed on the second light-receiving surface 4 in the solar battery cell A, the line width of the grid electrode 44 is desirably set to not less than 50 µm nor more than 120 µm.

Further, FIG. 15 is a graph illustrating relationships between a height and conversion efficiency of the first light-receiving surface 3 where the height (thin line height) of the grid electrode 44 in a single-layer structure formed on the second light-receiving surface 4 of the solar battery cell A was changed from about 7 µm to about 40 µm.

As illustrated in FIG. 15, when the height of the grid electrode 44 in a single-layer structure is not less than 10 µm nor more than 40 µm, 18.5% or more of the conversion efficiency of the first light-receiving surface 3 is achieved. Thus, when the grid electrodes 44 in a single-layer structure are formed on the second light-receiving surface 4 in the solar battery cell A, the height of the grid electrode 44 is desirably set to not less than 10 µm nor more than 40 µm.

As has been explained with reference to FIG. 14 and FIG. 15 above, when the grid electrodes 44 formed on the second light-receiving surface 4 are formed in a single-layer structure in the solar battery cell A, the specific dimensions are desired that the line width is not less than 50 µm nor more than 120 µm and the height is not less than 10 µm nor more than 40 µm.

The solar battery cell A constituted as explained above has characteristics that the conversion efficiency is higher than ever before and the conversion efficiency of the first light-receiving surface 3 and the conversion efficiency of the second light-receiving surface 4 are almost equivalent by using a silicon substrate thinner than ever before and forming a double-sided light-receiving type. Specifically, the conversion efficiency of the first light-receiving surface 3 is equal to or more than 18.5%, and the conversion efficiency ratio of the first light-receiving surface 3 and the second light-receiving surface 4 is equal to or more than 93%, or 98 to 102%. The double-sided light-receiving type solar battery cell A with high conversion efficiency as above is fabricated, and thereby when, for example, a solar battery module constituted by the cells is installed toward the east-west direction, the peak of a power generation amount for one day occurs two times, resulting in that efficient power generation is performed. Additionally, the power generation amounts at the two peaks are almost equivalent, so that in terms of installed capacity design of an inverter or the like incidental to the solar battery module, there is no waste and efficient electric power collection is achieved.

Further, when a solar battery module is fabricated by using the solar battery cells A according to this embodiment, warpage, cracks, and the like of the cells that are caused by wiring work are suppressed, so that it becomes possible to constitute a solar battery module with a high yield in a module production step.

Hitherto, an example of the embodiment of the present invention is described, but the present invention is not limited to the illustrated embodiment. It is obvious that those skilled in the art could think of various kinds of changed examples and modified examples within a scope of the ideas described in the claims, and it is naturally understood that they also belong to the technical scope of the present invention.

In the above-described embodiment, the diffusion is performed through the steps of forming the high-concentration diffusion regions (both p-type and n-type) and thereafter forming the low-concentration diffusion regions (p-type and n-type), but the formation method of the diffusion layers is not necessarily limited to this method. For example, a method of forming the high-concentration diffusion regions (p-type and n-type) and the low-concentration diffusion regions (p-type and n-type) on the light-receiving surfaces of the semiconductor substrate W may also be a method in which, after the low-concentration diffusion regions are formed on the whole light-receiving surfaces of the semiconductor substrate W, additional heat treatment is performed, with the phosphorus silicate glass films (or boron silicate glass films) being left at portions where to form the high-concentration diffusion regions, and thereby the high-concentration diffusion regions are formed.

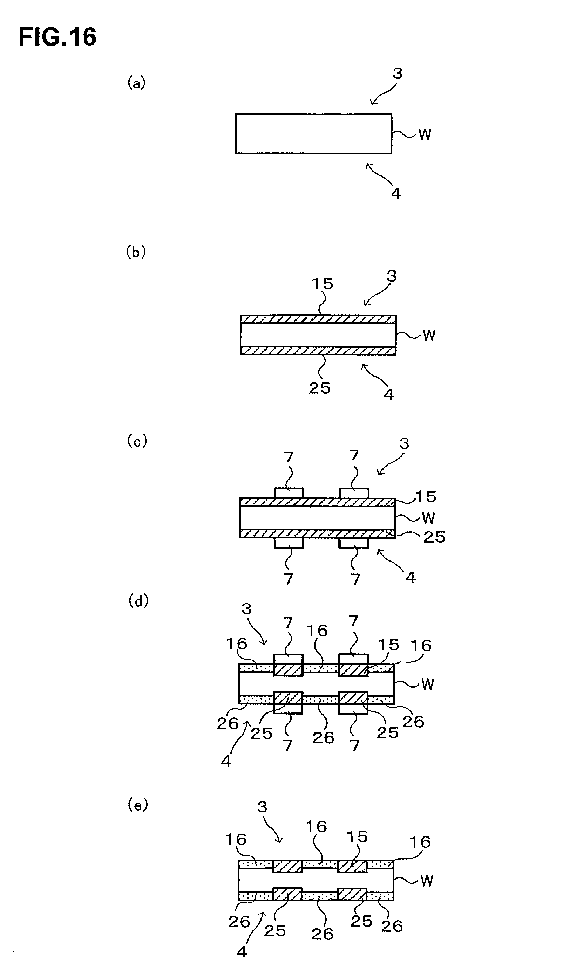

Further, another possible method for the boron diffusion and the phosphorus diffusion may be a method in which liquids or solids containing the respective elements are applied on the surfaces (first light-receiving surface and second light-receiving surface) of the substrate W in advance to then be thermally treated, thereby simultaneously forming the high-concentration p-type diffusion regions and the high-concentration n-type diffusion regions. Hereinafter, a case where the boron diffusion and the phosphorous diffusion on the substrate W are simultaneously performed will be described with reference to FIG. 16(a) to FIG. 16(e). Since the steps except steps relating to the boron diffusion and the phosphorus diffusion are performed by the same methods as those in the above-described steps in FIG. 1(a) to FIG. 1(n), only explanatory views of the steps of performing the boron diffusion and the phosphorus diffusion are illustrated in FIG. 16(a) to FIG. 16(e).

As illustrated in FIG. 16(a) and FIG. 16(b), liquid or solid containing a boron element is applied or made to adhere on the first light-receiving surface 3 of the substrate W, to then be dried, and liquid or solid containing a phosphorus element is applied or made to adhere on the second light-receiving surface 4 of the substrate W, to then be dried, and thereafter heat treatment is performed in a furnace set to, for example, 950°C to form the high-concentration p-type diffusion region 15 on the whole first light-receiving surface 3 and form the high-concentration n-type diffusion region 25 on the whole second light-receiving surface 4.

Next, as illustrated in FIG. 16(c), the first light-receiving surface 3 on which the high-concentration p-type diffusion region 15 is formed is coated with a resist film 7 in a predetermined pattern with, for example, a 10 to 30 µm thickness, to then be dried in a 180°C hot-air drying furnace. Next, the high-concentration n-type diffusion region 25 is coated with a resist film 7 in a predetermined pattern with, for example, a 10 to 30 µm thickness, to then be dried in a 180°C hot-air drying furnace. It is preferable to use a material having hydrofluoric acid resistance and nitric acid resistance and peelable by an alkaline solution.

Next, the substrate W on which the resist films 7 are printed on the first light-receiving surface 3 and the second light-receiving surface 4 is immersed in, for example, a fluoro nitric acid solution, and by etching the high-concentration p-type diffusion region 15 and the high-concentration n-type diffusion region 25 on portions, of the surfaces of the substrate W, where the resist films 7 are not printed, the low-concentration p-type diffusion regions 16 and the low-concentration n-type diffusion regions 26 are formed as illustrated in FIG. 16(d).

Next, the resist films are peeled by the alkaline solution, so that the resist films 7 both on the front surface and the rear surface are removed, and as illustrated in FIG. 16(e), the high-concentration p-type diffusion regions and the high-concentration n-type diffusion regions are simultaneously formed.

Further, in the above-described embodiment, the case where the high-concentration diffusion regions are formed both on the first light-receiving surface 3 and the second light-receiving surface 4 of the substrate W is described, but the present invention is not limited to this. For example, it is also possible to form an entirely uniform p-type diffusion layer on the first light-receiving surface 3 and form the high-concentration diffusion regions and the low-concentration diffusion regions only on the second light-receiving surface 4. Further, it is also possible to form an entirely uniform diffusion layer both on the first light-receiving surface 3 and the second light-receiving surface 4.

Forming the entirely uniform diffusion layer on one or both of the first light-receiving surface 3 and the second light-receiving surface 4 makes it possible to achieve a great cost reduction because the resist printing step and the resist removing step are reduced. Moreover, owing to a reduction in the heat treatment step, a reduction in thermal damage to the substrate W can also be achieved.

### [Industrial Applicability]

The present invention is applicable to a solar battery cell.

## Claims

1. A solar battery cell, comprising:
an n-type silicon substrate having a thickness of not less than 100 µm nor more than 250 µm;
a p-type diffusion layer formed on a first light-receiving surface being a front surface of the silicon substrate;
an n-type diffusion layer formed on a second light-receiving surface being a rear surface of the silicon substrate;
an anti-reflection film formed on the p-type diffusion layer and the n-type diffusion layer;
a plurality of grid electrodes and a plurality of busbar electrodes that are formed on part of the p-type diffusion layer; and
a plurality of grid electrodes and a plurality of busbar electrodes that are formed on part of the n-type diffusion layer, wherein
the grid electrodes provided on the first light-receiving surface are each formed in a manner that two layers of a first electrode layer and a second electrode layer are stacked in the order from the silicon substrate side,
power generation capacity of the first light-receiving surface is equal to or more than 18.5% in terms of conversion efficiency, and
conversion efficiency of the second light-receiving surface is equal to or more than 93% of conversion efficiency of the first light-receiving surface.

2. The solar battery cell according to claim 1, wherein
the thickness of the silicon substrate is not less than 100 µm nor more than 210 µm,
the grid electrodes provided on the first light-receiving surface and the second light-receiving surface are each formed in a manner that two layers of a first electrode layer and a second electrode layer are stacked in the order from the silicon substrate side, and
the conversion efficiency of the second light-receiving surface is not less than 98% nor more than 102% of the conversion efficiency of the first light-receiving surface.

3. The solar battery cell according to claim 1 or 2, wherein
the number of the busbar electrodes provided on the first light-receiving surface and the number of the busbar electrodes provided on the second light-receiving surface are each not less than three nor more than six.

4. The solar battery cell according to any one of claims 1 to 3, wherein
contact resistance of the first electrode layer with the silicon substrate is equal to or less than 5.0 x 10⁻³ Ω•cm².

5. The solar battery cell according to any one of claims 1 to 4, wherein
specific volume resistivity of the second electrode layer is equal to or less than 5.0 x 10⁻⁶ Ω•cm.

6. The solar battery cell according to any one of claims 1 to 5, wherein
a plurality of high-concentration p-type diffusion regions and low-concentration p-type diffusion regions each adjacently located between the high-concentration p-type diffusion regions are formed in the p-type diffusion layer,
a plurality of high-concentration n-type diffusion regions and low-concentration n-type diffusion regions each adjacently located between the high-concentration n-type diffusion regions are formed in the n-type diffusion layer, and
the grid electrodes are each formed on the plurality of high-concentration p-type diffusion regions and the plurality of high-concentration n-type diffusion regions.

7. The solar battery cell according to any one of claims 1 to 5, wherein
an entirely uniform p-type diffusion region is formed in the p-type diffusion layer, and
an entirely uniform n-type diffusion region is formed in the n-type diffusion layer.

8. The solar battery cell according to any one of claims 1 to 5, wherein
an entirely uniform p-type diffusion region is formed in the p-type diffusion layer,
a plurality of high-concentration n-type diffusion regions and low-concentration n-type diffusion regions each adjacently located between the high-concentration n-type diffusion regions are formed in the n-type diffusion layer, and
the grid electrodes are each formed on the plurality of high-concentration n-type diffusion regions.

9. The solar battery cell according to any one of claims 1 to 8, wherein
the grid electrodes and the busbar electrodes are each formed of either Ag or Ag and aluminum metal.

10. The solar battery cell according to any one of claims 1 to 9, wherein
an insulating film for passivation is formed between the p-type diffusion layer and the anti-reflection film, and the insulating film for passivation is formed of Al₂O₃ or a thermally oxidized film.

11. The solar battery cell according to any one of claims 1 to 10, wherein
an insulating film for passivation is formed between the n-type diffusion layer and the anti-reflection film, and the insulating film for passivation is formed of SiN or a thermally oxidized film.

12. The solar battery cell according to claim 2, wherein
a line width of the grid electrodes provided on the first light-receiving surface and the second light-receiving surface is not less than 50 µm nor more than 90 µm, and a height of the grid electrodes is not less than 15 µm nor more than 50 µm.

13. The solar battery cell according to claim 1, wherein
a line width of the grid electrodes provided on the first light-receiving surface is not less than 50 µm nor more than 90 µm and a height of the grid electrodes is not less than 15 µm nor more than 50 µm, and a line width of the grid electrodes provided on the second light-receiving surface is not less than 50 µm nor more than 120 µm and a height of the grid electrodes is not less than 10 µm nor more than 40 µm.

14. A method of manufacturing the solar battery cell according to any one of claims 1 to 13, wherein
the p-type diffusion layer is formed in such a manner that a single-crystal silicon substrate is thermally treated in an atmosphere of boron tribromide gas being a source gas.

15. A method of manufacturing the solar battery cell according to any one of claims 1 to 13, wherein
the p-type diffusion layer is formed in such a manner that liquid or solid containing a boron element is applied or made to adhere on a single-crystal silicon substrate in advance and then is thermally treated.

16. A method of manufacturing the solar battery cell according to any one of claims 1 to 13, wherein
the p-type diffusion layer is formed in such a manner that a gas containing a boron element is ion implanted onto a single-crystal silicon substrate.

17. A method of manufacturing the solar battery cell according to any one of claims 1 to 13, wherein
the n-type diffusion layer is formed in such a manner that a single-crystal silicon substrate is thermally treated in an atmosphere of phosphorus oxychloride gas being a source gas.

18. A method of manufacturing the solar battery cell according to any one of claims 1 to 13, wherein
the n-type diffusion layer is formed in such a manner that liquid or solid containing a phosphorus element is applied or made to adhere on a single-crystal silicon substrate in advance and then is thermally treated.

19. A method of manufacturing the solar battery cell according to any one of claims 1 to 13, wherein
the n-type diffusion layer is formed in such a manner that a gas containing a phosphorus element is ion implanted onto a single-crystal silicon substrate.

20. A method of manufacturing the solar battery cell according to any one of claims 1 to 13, wherein
the first electrode layer formed on the p-type diffusion layer is formed in such a manner that a conductive paste containing Ag and aluminum metal with a composition containing not less than 1.0 wt% nor more than 5.0 wt% of aluminum metal with respect to Ag is screen printed to be burned.

21. A method of manufacturing the solar battery cell according to claim 2 or 12, wherein
the first electrode layer formed on the n-type diffusion layer is formed in such a manner that a conductive paste containing Ag is screen printed to be burned.

22. A method of manufacturing the solar battery cell according to any one of claims 1 to 13, wherein
a second electrode layer formed on the first electrode layer is formed in such a manner that a conductive paste containing Ag is screen printed to be burned.
